# EUROPEAN PATENT APPLICATION

(11) **EP 2 485 272 A2**
(43) Date of publication of application: **08.08.2012**
(21) Application number: 10820853.9
(22) Date of filing: 30.09.2010
(51) Int. Cl.: H01L 31/042

(54) **SOLAR POWER GENERATION APPARATUS AND MANUFACTURING METHOD THEREOF**

(30) Priority: 30.09.2009 KR 20090093604
(71) Applicant: LG Innotek Co., Ltd., Seoul 100-714 (KR)
(72) Inventor: JEE, Suk Jae, Seoul 100-714 (KR); KIM, Kyung Am, Seoul 100-714 (KR)
(74) Representative: Novagraaf Technologies
(86) International application number: PCT/KR2010/006707
(87) International publication number: WO 2011/040780

(57) **Abstract**

Provided are a solar cell apparatus and a method of manufacturing the same. The solar cell apparatus includes a substrate, a rear electrode layer disposed on the substrate, a thin film layer disposed on the rear electrode layer, the thin film layer including a Group VI―based element, a light absorption layer disposed on the thin film layer, and a front electrode layer on the light absorption layer.

## Description

### BACKGROUND

Embodiments relate to a solar cell apparatus and a method of manufacturing the solar cell apparatus.

As the demands for energy increases, solar cells that convert solar energy into electric energy are being actively developed. Particularly, copper-indium-gallium-selenide (CIGS) -based solar cells that are p-n heterojunction devices are being widely used. Here, such a CIGS-based solar cell has a substrate structure including a glass substrate, a metal rear electrode layer, a p-type CIGS-based light absorption layer, a high resistance buffer layer, and an n-type window layer.

To form the CIGS-based light absorption layer, a selenization process is performed after a CIG layer is formed.

However, in the above-described process, there are limitations that it is difficult to control a stoichiometric composition ratio of selenium (Se) within the CIGS-based light absorption layer and also consumption of Se increases.

### SUMMARY

Embodiments provide a solar cell apparatus including a light absorption layer having improved properties and a method of manufacturing the same.

In one embodiment, a solar cell apparatus includes: a substrate; a rear electrode layer disposed on the substrate; a thin film layer disposed on the rear electrode layer, the thin film layer including a Group VI-based element; a light absorption layer disposed on the thin film layer; and a front electrode layer on the light absorption layer.

In another embodiment, a solar cell apparatus includes: a substrate; a rear electrode layer disposed on the substrate; a light absorption layer disposed on the rear electrode layer, the light absorption layer including a Group I-III-VI-based compound; and a front electrode layer disposed on the light absorption layer, wherein the light absorption layer includes: a first area adjacent to the rear electrode layer, the first area including Group VI-based elements at a first composition; and a second area disposed on the first area, the second area including the Group VI-based elements at a second composition less than the first composition.

In further another embodiment, a method of manufacturing a solar cell apparatus includes: forming a rear electrode layer on a substrate; forming a thin film layer including a Group VI-based element on the rear electrode layer; supplying a Group I-based element and a Group III-based element on the thin film layer to form a light absorption including a group I-III-V-based compound on the rear electrode layer; and forming a front electrode layer on the light absorption layer.

The details of one or more embodiments are set forth in the accompanying drawings and the description below. Other features will be apparent from the description and drawings, and from the claims.

### BRIEF DESCRIPTION OF THE DRAWINGS

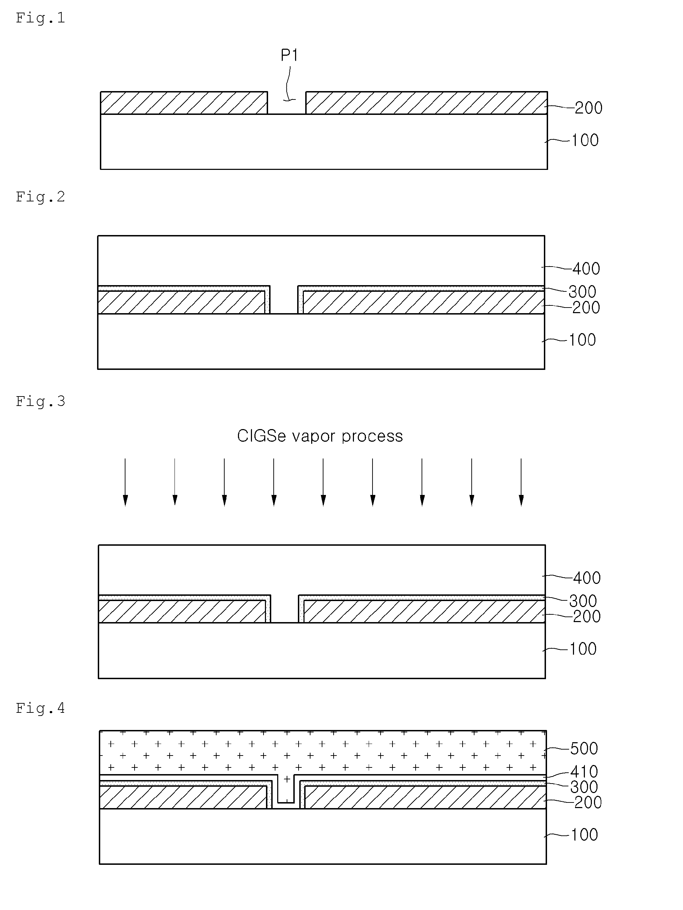

Figs. 1 to 9 are sectional views illustrating a process of manufacturing a solar cell according to an embodiment.

### DETAILED DESCRIPTION OF THE EMBODIMENTS

In the description of embodiments, it will be understood that when a substrate, layer, film, or electrode is referred to as being 'on' or 'under' another substrate, layer, film, or electrode, the terminology of `on' and 'under' includes both the meanings of 'directly' and 'indirectly'. Further, the reference about 'on' and 'under' each component layer will be made on the basis of drawings. In addition, the sizes of elements and the relative sizes between elements may be exaggerated for further understanding of the present disclosure.

Hereinafter, a solar cell according to an embodiment and a method of manufacturing the solar cell will be described in detail with reference to Figs. 1 to 9.

Referring to Fig. 1, a rear electrode layer 200 is formed on a substrate 100, and a plurality of first through holes P1 are defined in the rear electrode layer 200. Thus, the rear electrode layer 200 is divided into a plurality of rear electrodes by the first through holes P1.

The substrate 100 may be formed of glass. Also, the substrate 100 may include a ceramic substrate, a metal substrate, and a polymer substrate.

For example, the glass substrate may be formed of soda lime glass or high strained point soda glass. The metal substrate may include a substrate formed of a stainless steel or titanium. The polymer substrate may be formed of polyimide.

The substrate 100 may be transparent. The substrate 100 may be rigid or flexible.

The rear electrode layer 200 may be formed of a conductor such as a metal.

For example, the rear electrode layer 200 is formed through a sputtering process using molybdenum (Mo) as a target.

This is done because of high conductivity of Mo, ohmic contact with a light absorption layer, and high-temperature stability under Se atmosphere.

A Mo thin film that is the rear electrode layer 200 should have a low specific resistance as an electrode and also superior adhesion with the substrate 100 so that it prevents exfoliation from occurring due to a difference of a thermal expansion coefficient.

However, the present disclosure is not limited thereto. For example, the rear electrode layer 200 may be formed of Mo doped with Na ions.

Although not shown, the rear electrode layer 200 may include at least one layer. When the rear electrode layer 200 includes a plurality of layers, the layers constituting the rear electrode layer 200 may be formed of materials different from each other.

After the rear electrode layer 200 is formed on the substrate 100, the first through holes P1 may be defined through a patterning process. That is, the rear electrode layer 200 may be divided into a plurality of rear electrodes by the first through holes P1.

A top surface of the substrate 100 may be selectively exposed through the first through holes P1.

For example, the first through holes P1 may be patterned through a laser process or a mechanical process. Each of the first through holes P1 may have a width of about 80 µm ± 20.

The rear electrode layer 200 may be divided into the rear electrodes each having a stripe or matrix shape by the first through holes P1. Here, the rear electrodes may correspond to cells, respectively.

The present disclosure is not limited to the above-described shape of the rear electrode layer 200. For example, the rear electrode layer 200 may have various shapes.

Referring to Fig. 2, a thin film layer 400 containing VI-based elements is formed on the substrate 100 on which the rear electrode layer 200 is formed. For example, the thin film layer 400 may be formed of selenium (Se). The thin film layer 400 may have a thickness of about 1 µm to about 5 µm.

The thin film layer 400 may be formed through a sputtering process using selenium (Se) as a target. Alternatively, the thin film layer 400 may be formed through evaporation using a Se cell.

The thin film layer 400 may have a thickness greater by 1 time to 5 times than that of the rear electrode layer 200.

The thin film layer 400 may fill a gap within the first through holes P and contact a surface of the exposed substrate 100. That is, the thin film layer 400 may be formed on inner surfaces of the first through holes P1.

The thin film layer 400 may be formed on bottom surfaces of the first through holes P1 to prevent a leakage current from occurring between the rear electrode layer 200 divided into the plurality of rear electrodes.

The thin film layer 400 may be formed to have a predetermined thickness on the substrate 100 including the rear electrode layer 200. Thus, when a CIGS light absorption layer that will be formed later is formed, a stoichiometric composition ratio of Group VI―based elements may be easily controlled.

When the thin film layer 400 is formed on the rear electrode layer 200, a metal element constituting the rear electrode layer 200 and a Group VI element of the thin film layer 400 may mutually react with each other and thus be coupled to each other.

Accordingly, an alloy layer 300 may be formed on an interface between the rear electrode layer 200 and the thin film layer 400.

For example, the alloy layer 300 may be formed of molybdenum selenide that is a compound of Mo and Se. In detail, the alloy layer 300 may be formed of MoSe₂.

That is, the alloy layer 300 may be formed along a surface of the rear electrode layer 200. Also, the alloy layer 300 may serve as a protection layer of the rear electrode layer 200 or induce ohmic-contact with the absorption layer.

Referring to Figs. 3 and 4, a light absorption layer 500 containing Group I-III-VI-based compounds may be formed on the rear electrode layer 200.

Specifically, the light absorption layer 500 may be formed of a copper-indium-gallium-selenide-based (Cu(In, Ga) Se₂; CIGS-based) compound.

Alternatively, the light absorption layer 500 may be formed of a copper-indium-selenide based (CuInSe₂; CIS-based) compound or a copper-gallium-selenide based (CuGaSe₂; CGS-based) compound.

For example, the light absorption layer 500 may have a thickness of about 2 µm to about 4 µm.

The light absorption layer 500 may receive external light to convert the incident light into electric energy. The light absorption layer 500 generates a photoelectro-motive force by a photovoltaic effect.

Referring again to Fig. 3, the light absorption layer 500 may be formed through the evaporation. Specifically, the light absorption layer 500 may be formed through co-evaporation.

To form the light absorption layer 500, a Group I element and a Group III element are supplied onto the thin film layer 400 through evaporation.

For example, copper, indium, and gallium may be supplied onto the thin film layer 400 to form the light absorption layer 500. Alternatively, copper, indium, gallium, and selenium may be supplied onto the thin film layer 400 to form the light absorption layer 500.

That is, the light absorption layer 500 may be formed through evaporation using a first source containing a Group I element and a second source containing a Group III element. For example, the light absorption layer 500 may be formed through evaporation using a copper source, an indium source, a gallium source and/or a selenium source.

Here, the copper source may be a copper cell formed of copper heated at a temperature of about 1,300 °C to about 1,500 °C. The indium source may be an indium cell formed of indium heated at a temperature of about 1,100 °C to about 1,200°C. The gallium source may be a gallium cell formed of gallium heated at a temperature of about 1,100°C to about 1,300 °C. The selenium source may be a selenium cell formed of selenium heated at a temperature of about 200°C to about 400°C.

In the process of forming the light absorption layer 500, copper, indium, gallium, and selenium of the copper source, the indium source, the gallium source, and the selenium source are evaporated at a constant rate and high temperature, respectively. Thus, the evaporated copper, indium, and gallium reacts with the selenium contained in the thin film layer 400 to form a copper-indium-gallium-selenide-based compound. Also, the evaporated selenium may be provided on the thin film layer 400 to form a CIGS light absorption layer having a uniform composition.

Here, it may prevent the selenium having high volatility contained in the thin film layer 400 from being separated due to the copper, indium, and gallium deposited on the thin film layer 400. Thus, the most selenium contained in the thin film layer 400 may react with the evaporated copper, indium, and the gallium to form the light absorption layer 500 having a copper-gallium-indium-selenide-based crystal structure.

That is, a copper-indium-gallium-based metal precursor layer may be formed on the thin film layer 400, and the selenium contained in the thin film layer 400 may be diffused on the metal precursor to form the light absorption layer 500. Here, it may prevent the selenium contained in the thin film layer 400 from being separated due to the metal precursor layer.

The selenium may be diffused again to a MoSe2 layer disposed under the thin film layer 400 by thermal energy applied in the process of forming the light absorption layer 500. Thereafter, a thickness of the MoSe2 layer increases in contradistinction to its initial thickness. Then, when the MoSe2 layer has a thickness greater than a critical diffusion distance of the selenium, the diffusion process of the selenium is not performed any more.

Also, when the most thin film layer 400 may be coupled to the copper, indium, and gallium to form the light absorption layer 500, a lower area 410 of the thin film layer 400 adjacent to the rear electrode layer 200 may remain as it is without reacting with the above-described materials. Here, the remaining thin film layer 410 may have a thickness of about 10 nm to about 100 nm.

Alternatively, the entire selenium contained in the thin film layer 400 may react so that the thin film layer 400 does not remain between the rear electrode layer 200 and the light absorption layer 500. That is, the alloy layer 300 may directly contact the light absorption layer 500.

In general, when the light absorption layer is formed, the consumption of the selenium is greater by about 15 times to about 20 times than those of the copper, indium, and gallium. Also, since the selenium has the high volatility, the selenium is not well deposited when compared to those of the copper, indium, and gallium. Thus, the selenium may have nonuniform composition on the CIGS-based light absorption layer.

In the current embodiment, since the CIGS-based light absorption layer 500 is formed after the thin film layer 400 formed of selenium is formed on the substrate 100 before the light absorption layer 500 is formed, a stoichiometric composition ratio of the light absorption layer 500 may be controlled.

Also, since it prevents the selenium contained in the thin film layer 400 from being evaporated, the consumption of the selenium may be reduced. That is, the copper, indium, and gallium may be deposited on the thin film layer 400 to prevent the selenium contained in the thin film layer 400 from being evaporated.

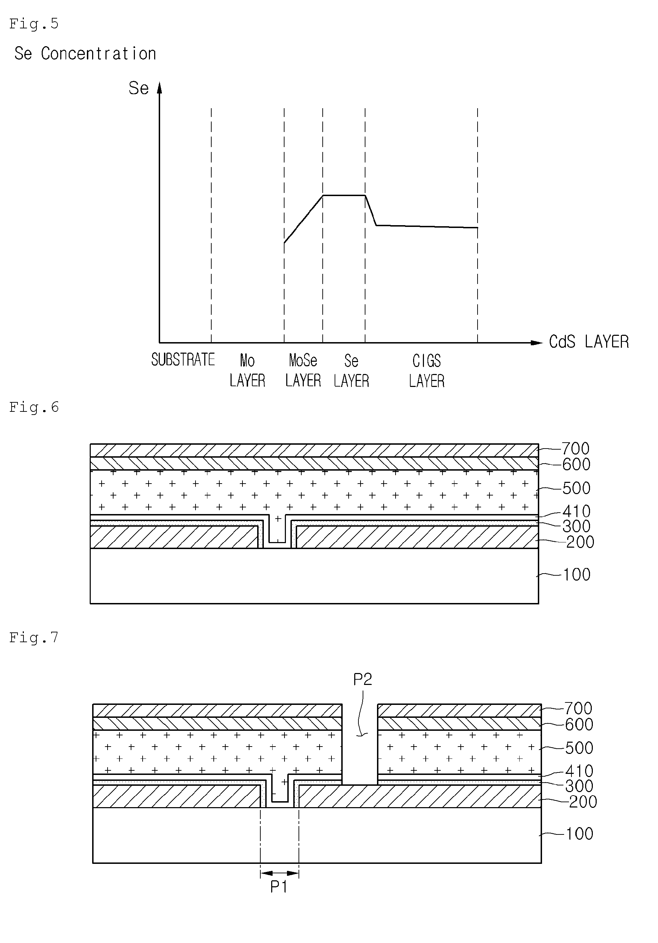

Also, as shown in Fig. 5, the selenium may have the highest concentration distribution on the remaining thin film layer 410. Also, the light absorption layer 500 may have a first area and a second area.

The first area is adjacent to the rear electrode layer 200. In detail, the first area is adjacent to the remaining thin film layer 410. In more detail, the first area is disposed on the remaining thin film layer 410.

The first area may contain a relatively large amount of selenium. In more detail, the first area may be formed of a CIGS-based compound having a relatively high selenium composition.

The second area is adjacent to a front electrode layer 800. In detail, the second area is adjacent to a buffer layer 600. The second area is disposed on the first area. The second area may have a thickness corresponding to about 80% to about 99% of that of the light absorption layer 500.

The second area may contain a relatively small amount of selenium. In more detail, the second area may contain a selenium amount less than those of the first area and the remaining thin film layer 410.

The second area is formed of a CIGS―based compound having a relatively low selenium composition. The selenium composition in the second area may be less than that in the first area. Also, the second area may have constant concentration distribution regardless of a position thereof.

The remaining thin film layer 410 may be disposed also on the inner surfaces of the first through holes P1. Thus, the remaining thin film layer 410 may be disposed on the inner surfaces of the first through holes P1 to prevent shunt path between the rear electrodes.

Referring to Fig. 6, the buffer layer 600 and a high resistance buffer layer 700 are formed on the light absorption layer 500.

The buffer layer 600 may be formed on the light absorption layer 500 as at least one layer. Also, the buffer layer 600 may be formed of cadmium sulfide (CdS) through chemical bath deposition (CBD).

Here, the buffer layer 600 may be an N-type semiconductor layer, and the light absorption layer 500 may be a P-type semiconductor layer. Thus, the light absorption layer 500 and the buffer layer 600 may be pn-junctioned to each other.

The high resistance buffer layer 700 may be formed on the buffer layer 600 as a transparent electrode layer.

For example, the high resistance buffer layer 700 may be formed of one of ITO, ZnO, and i-ZnO.

The high resistance buffer layer 700 may be formed as a zinc oxide layer through a sputtering process using zinc oxide (ZnO) as a target.

The buffer layer 600 and the high resistance buffer layer 700 may be disposed between the light absorption layer 500 and a front electrode that is formed later.

That is, since differences of a lattice constant and energy band gap between the light absorption layer 500 and the front electrode are large, the buffer layer 600 and the high resistance buffer layer 700 respectively having a bad gap corresponding to a middle value of the band gaps of the light absorption layer 500 and the front electrode may be inserted into the light absorption layer 500 and the front electrode to realize good bonding between the light absorption layer 500 and the front electrode.

Although two buffer layers 600 are formed on the light absorption layer 50 in the current embodiment, the buffer layer 600 may be formed as a single layer.

Referring to Fig. 7, second through holes P2 passing through the high resistance buffer layer 700, the buffer layer 600, the light absorption layer 500, the remaining thin film layer 410, and the alloy layer 300 are defined. The rear electrode layer 200 may be exposed through the second through holes P2.

Alternatively, the surface of the alloy layer 300 may be exposed through the second through holes P2.

The second through holes P2 may be formed through a laser process or a mechanical patterning process.

The second through holes P2 may be formed adjacent to the first through holes P1. For example, each of the second through holes P2 may have a width of about 80 µm ± 20 µm. Also, a gap between each of the second through holes P2 and each of the first through holes P1 may be about 80 µm ± 20 µm.

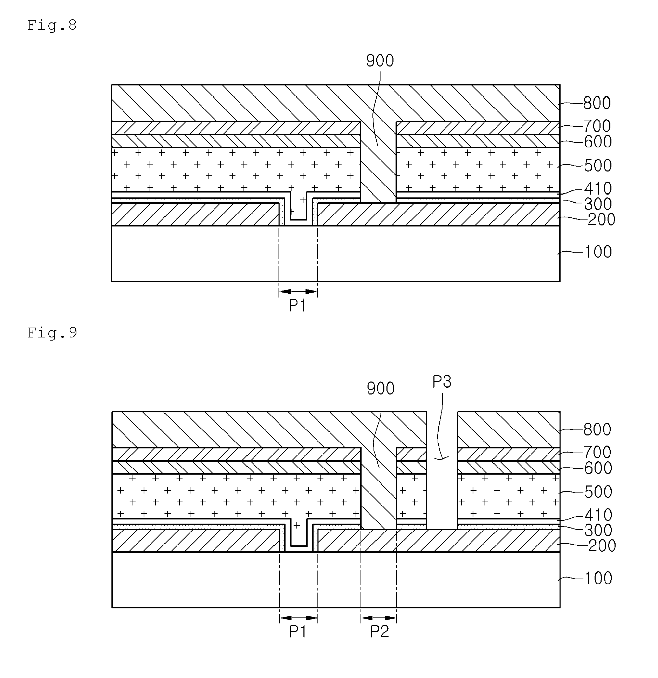

Referring to Fig. 8, a transparent conductive material is stacked on the high resistance buffer layer 700 to form a front electrode layer 800.

When the front electrode layer 800 is formed, the transparent conductive material may be inserted into the second through holes P2 to form connection wires 900.

The connection wires 900 may be directly connected to the rear electrode layers 200 through the second through holes P2.

The front electrode layer 800 may be formed of zinc oxide doped with aluminum (Al) or alumina (Al₂O₃) through a sputtering process.

The front electrode layer 800 may be a window layer for forming a pn junction with the light absorption layer 500. Since the front electrode layer 800 serves as a transparent electrode of a front surface of the solar cell, the front electrode layer 800 may be formed of zinc oxide (ZnO) having high light transmittance and high conductivity.

Thus, the Al or Al₂O₃ may be doped into the ZnO to form an electrode having a low resistance valve.

A ZnO thin film that is the front electrode layer 800 may be formed through a radio frequency (RF) sputtering method using a ZnO target, a reactive sputtering method using a Zn target, or a metal organic chemical vapor deposition method.

Also, the ZnO thin film may have a dual structure in which an indium tin oxide (ITO) thin film having superior electro-optical properties is deposited on the ZnO thin film.

Referring to Fig. 9, third through holes P3 passing through the front electrode layer 800, the high resistance buffer layer 700, the buffer layer 600, the light absorption layer 500, the remaining thin film layer 410, and the alloy layer 300 are defined.

The rear electrode layer 200 may be selectively exposed through the third through holes P3. Alternatively, the surface of the alloy layer 300 may be selectively exposed through the third through holes P3.

The third through holes P3 may be formed adjacent to the second through holes P2.

For example, each of the third through holes P3 may have a width of about 80 µm ± 20 µm. Also, a gap between each of the third through holes P3 and each of the second through holes P2 may be about 80 µm ± 20 µm.

The third through holes P3 may be formed by irradiating a laser or through a mechanical method such as a tip.

When the third through holes P3 are formed, the surface of the rear electrode layer 200 may be protected by the alloy layer 300.

That is, since the alloy layer 300 is formed on the surface of the rear electrode layer 200, the alloy layer 300 may serve as a protection layer of the rear electrode layer 200 when an etching process using the laser or tip to prevent the rear electrode layer 200 from being damaged.

Each of the light absorption layer 300, the buffer layer 400, the high resistance buffer layer 500, and the front electrode layer 600 may be separated from each other into cell units.

The cells may be connected to each other through the connection wires 700. That is, the connection wires 700 may physically and electrically connect the rear electrode layers 200 and the front electrodes 600 of the cells adjacent to each other.

The light absorption layer 500 may be formed using Group I-based elements and Group III-based elements after the thin film layer 400 containing a Group VI element is formed. That is, the Group VI element may be deposited first, and then the Group I element and the Group III element may be deposited to form the light absorption layer 500.

Thus, the Group VI element may be uniformly distributed on the light absorption layer 500. That is, since the Group VI element may have a low evaporation temperature, it may be difficult to uniformly distribute the Group VI element on the light absorption layer 500.

Here, the thin film layer 400 may be formed first, and then the Group I element and the Group III element may be deposited. Thereafter, the Group VI element of the thin film layer 400 may be diffused into the Group I-III-based metal precursor layer to form the light absorption layer 500. Thus, the Group VI element may be uniformly distributed on the light absorption layer 500 to prevent the Group VI element from lacking.

Thus, in the solar cell apparatus according to the embodiment, it may prevent performance of the light absorption layer 500 from being reduced by the lacking of the Group VI element to form the light absorption layer 500 having improved properties. Thus, the solar cell apparatus according the embodiment may have improved photoelectric conversion efficiency.

Also, the thin film layer 410 remaining between the rear electrodes may be disposed to prevent the leakage current between the cells from occurring.

Therefore, the solar cell apparatus according to the embodiment may have improved electrical properties.

The light absorption layer of the solar cell apparatus according to the embodiment may be formed using the Group I-based elements and the Group III-based elements after the thin film layer containing the Group VI element is formed. That is, the Group VI element may be deposited first, and then the Group I element and the Group III element may be deposited to form the light absorption layer.

Thus, the Group VI may be uniformly distributed on the light absorption layer. That is, since the Group VI element may have the low evaporation temperature, it may be difficult to uniformly distribute the Group VI element on the light absorption layer.

Here, the thin film layer may be formed first, and then the Group I element and the Group III element may be deposited. Thereafter, the Group VI element of the thin film layer may be diffused into the Group I-III-based metal precursor layer to form the light absorption layer. Thus, the Group VI element may be uniformly distributed on the light absorption layer to prevent the Group VI element from lacking.

Thus, in the solar cell apparatus according to the embodiment, it may prevent performance of the light absorption layer from being reduced by the lacking of the Group VI element to form the light absorption layer having the improved properties. Thus, the solar cell apparatus according the embodiment may have improved photoelectric conversion efficiency.

Also, when the rear electrode layer is divided into the plurality of rear electrodes by the plurality of through holes, the thin film layer may remain on the inner surfaces of the through holes. That is, the thin film layer may be disposed on the side surfaces of the rear electrodes to efficiently insulate the rear electrodes from each other. Therefore, it may prevent the rear electrodes from being short-circuited with each other, and also the solar cell apparatus according to the embodiment may have improved electrical properties.

The solar cell apparatus according to the embodiment may be applied to various solar cell fields.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A solar cell apparatus comprising:
a substrate;
a rear electrode layer disposed on the substrate;
a thin film layer disposed on the rear electrode layer, the thin film layer comprising a Group VI-based element;
a light absorption layer disposed on the thin film layer; and
a front electrode layer on the light absorption layer.

2. The solar cell apparatus according to claim 1, wherein a plurality of through holes are defined in the rear electrode layer, and
the thin film layer is disposed inside the through holes.

3. The solar cell apparatus according to claim 1, wherein the thin film layer comprises selenium.

4. The solar cell apparatus according to claim 1, comprising an alloy layer between the rear electrode layer and the thin film layer.

5. The solar cell apparatus according to claim 4, wherein the alloy layer comprises molybdenum selenide.

6. The solar cell apparatus according to claim 1, wherein the light absorption layer comprises a Group I-III-VI-based compound, and
a composition of the Group VI-based element of the light absorption layer gradually increase in a direction away from the thin film layer.

7. The solar cell apparatus according to claim 1, wherein the thin film layer has a thickness of about 10 nm to about 100 nm.

8. A solar cell apparatus comprising:
a substrate;
a rear electrode layer disposed on the substrate;
a light absorption layer disposed on the rear electrode layer, the light absorption layer comprising a Group I-III-VI-based compound; and
a front electrode layer disposed on the light absorption layer,
wherein the light absorption layer comprises:
a first area adjacent to the rear electrode layer, the first area comprising Group VI-based elements at a first composition; and
a second area disposed on the first area, the second area comprising the Group VI-based elements at a second composition less than the first composition.

9. The solar cell apparatus according to claim 8, wherein the Group VI-based element comprises selenium.

10. The solar cell apparatus according to claim 8, comprising a thin film layer disposed between the rear electrode layer and the light absorption layer, the thin film layer comprising the Group VI-based element.

11. The solar cell apparatus according to claim 8, wherein the Group VI-based element has uniform composition along the second area.

12. The solar cell apparatus according to claim 11, wherein the second area has a thickness corresponding to about 80% to about 90% of that of the light absorption layer.

13. A method of manufacturing a solar cell apparatus, the method comprising:
forming a rear electrode layer on a substrate;
forming a thin film layer comprising a Group VI-based element on the rear electrode layer;
supplying a Group I-based element and a Group III-based element on the thin film layer to form a light absorption comprising a group I-III-V-based compound on the rear electrode layer; and
forming a front electrode layer on the light absorption layer.

14. The method according to claim 13, wherein the thin film layer comprises selenium.

15. The method according to claim 13, comprising forming an alloy layer comprising selenide molybdenum between the thin film layer and the rear electrode layer.

16. The method according to claim 13, wherein a ratio of the rear electrode layer and the thin film layer is about 1:4 to about 1:5.

17. The method according to claim 13, wherein the Group I― based element comprises copper, and the Group III―based element comprises gallium or indium.

18. The method according to claim 13, comprising forming a plurality of through holes in the rear electrode layer,
wherein the thin film layer is formed inside the through holes.
